# EUROPÄISCHE PATENTSCHRIFT

(11) **EP 4 348 777 B1**
(45) Veröffentlichungstag und Bekanntmachung des Hinweises auf die Patenterteilung: **29.10.2025**
(21) Anmeldenummer: 22734497.5
(22) Anmeldetag: 02.06.2022
(51) Int. Cl.: H01S 5/024, H01S 5/12, H01S 5/028, H01S 5/40, H01S 5/026, H01S 5/042, H01S 5/16, H01S 5/20, H01S 5/06, H01S 5/22

(54) **LASERBARREN MIT VERRINGERTER LATERALER FERNFELDDIVERGENZ**
LASER BAR WITH REDUCED LATERAL FAR-FIELD DIVERGENCE
BARRES LASERS À DIVERGENCE EN CHAMP LOINTAIN LATÉRALE RÉDUITE

(30) Priorität: 03.06.2021 DE 102021114411
(43) Veröffentlichungstag der Anmeldung: 10.04.2024
(73) Patentinhaber: Ferdinand-Braun-Institut gGmbH, Leibniz-Institut für Höchstfrequenztechnik, 12489 Berlin (DE)
(72) Erfinder: KAROW, Matthias M., 10439 Berlin (DE); CRUMP, Paul, 10245 Berlin (DE); MIAH, Mohammad Jarez, 10369 Berlin (DE)
(74) Vertreter: Gulde & Partner
(86) Internationale Anmeldenummer: PCT/EP2022/065024
(87) Internationale Veröffentlichungsnummer: WO 2022/253946

(56) Entgegenhaltungen:
- US-A- 6 038 242
- US-A1- 2007 223 552
- US-A1- 2017 310 081
- US-A1- 2017 330 757

## Beschreibung

Die vorliegende Erfindung betrifft einen Laserbarren mit verringerter lateraler Fernfelddivergenz und insbesondere einen Laserbarren mit einem einheitlichen Temperaturprofil in lateraler Richtung zur Reduzierung der lateralen Fernfelddivergenz.

### Stand der Technik

Laserbarren bestehen typischerweise aus mehreren Breitstreifenlasern (engl. broad-area diode lasers, BALs), die in lateraler Richtung parallel nebeneinander liegend auf einem gemeinsamen Substrat angeordnet sind. Damit können insgesamt Ausgangsleistungen von 1500 W und mehr erreicht werden. Die Anzahl der in einem Laserbarren angeordneten Breitstreifenlaser kann dabei variieren, typische Werte hierfür liegen zwischen 5 und 200. Die laterale Streifenbreite der Breitstreifenlaser liegt typischerweise zwischen 5 µm und 100 µm, kann aber auch deutlich größer sein, wie etwa 1200 µm.

Üblicherweise werden die einzelnen Laserelemente als separate Emitterstrukturen in einer gemeinsamen Schichtstruktur ausgebildet, wobei für eine Separation der Emitterstrukturen zumeist eine Strukturierung der Ladungsträgerzuführung erfolgt, insbesondere über eine Strukturierung der einem n-Substrat gegenüberliegenden p-Kontaktschicht und der zugehörigen p-Kontakte. Über die p- und n-Kontakte erfolgt eine Injektion von Ladungsträgern in die zwischen den beiden Kontakten innerhalb der Schichtstruktur ausgebildete aktiven Zone. Da die injizierten Ladungsträger sich überwiegend auf direktem Weg ohne laterale Stromaufweitung in Richtung der aktiven Zone bewegen, kann durch entsprechende Trennstrukturen in der Ladungsträgerzuführung auch die Strahlungserzeugung innerhalb der aktiven Zone in lateraler Richtung entsprechend strukturiert werden. Als lokale Trennstrukturen zur Separierung der einzelnen Emitterstrukturen erfolgt dabei üblicherweise in der p-Kontaktschicht eine Implantation von Störstellen oder Fremdatomen, die Ausbildung von Gräben (engl. trenches) oder das lokale Einbringen von dielektrischen Abschnitten (z B. erzeugt durch ein Auffüllen von Gräben mit einem dielektrischen Material).

Bei einem herkömmlichen Laserbarren wird durch eine Strukturierung insbesondere der p-Kontaktschicht somit eine Vielzahl identischer Emitterstrukturen erzeugt. Die von diesen Emitterstrukturen emittierte Strahlung sollte somit weitgehend identische Eigenschaften aufweisen. Obwohl die einzelnen Emitterstrukturen identisch aufgebaut sind, stellt sich in Laserbarren mit hohem Füllfaktor und kleinen Abständen zwischen den einzelnen Emitterstrukturen bei den äußeren Emitterstrukturen jedoch eine andere Temperaturverteilung als bei den inneren Emitterstrukturen des Laserbarrens ein. Die inneren Emitterstrukturen zeigen ein weitgehend ähnliches Temperaturprofil mit einer einheitlichen Maximaltemperatur und einer geringen Temperaturmodulation im Bereich zwischen den Emitterstrukturen aufgrund der starken thermischen Kopplung untereinander. Das Temperaturprofil bei den äußeren Emitterstrukturen ist hingegen stark asymmetrisch und die Maximaltemperaturen fallen aufgrund des fehlenden thermischen Beitrags von weiter außen gelegenen Emitterstrukturen einseitig ab.

Es wurde von den Erfindern festgestellt, dass ein solches asymmetrisches Temperaturprofil dazu führt, dass die laterale Fernfelddivergenz der äußeren Emitterstrukturen breiter ist als die der inneren Emitterstrukturen, was wesentlich zur Verbreiterung der gesamten Barren-Fernfelddivergenz beiträgt. Dabei können bis zu 2/3 der Emitterstrukturen in einem Laserbarren von solchen asymmetrischen Temperaturprofilen und der daraus resultierenden Fernfeldverbreiterung betroffen sein.

Es wird weiterhin auf die folgenden Dokumente verwiesen:
- US 2017/330757 A1 (EICHLER) 16. November 2017 ;
- US 2007/223552 A1 (MUENDEL) 27. September 2007 ;
- US 2017/310081 A1 (LAUER) 26. Oktober 2017 ;
- US 6 038 242 A (YAMAMOTO) 14. März 2000.

### Offenbarung der Erfindung

Es ist daher eine Aufgabe der vorliegenden Erfindung, einen Laserbarren zur Verfügung zu stellen, bei dem durch eine Variation des Temperaturprofils in lateraler Richtung eine Verringerung der lateralen Fernfelddivergenz erreicht werden kann. Insbesondere soll durch eine solche Variation des Temperaturprofils in lateraler Richtung eine Anpassung der Temperatur der äußeren Emitterstrukturen an eine Temperatur der von den äußeren Emitterstrukturen eingeschlossenen inneren Emitterstrukturen erfolgen. Durch neuartige Barrenkonstruktionen und -anordnungen können die lateralen Temperaturverteilungen innerhalb der äußeren Emitter so eingestellt werden, dass sie möglichst nahe an denen der inneren Emitter liegen. Auf diese Weise können die Ausbildung eines asymmetrischen Temperaturprofils und das Auftreten einer dadurch bedingten Verbreiterung der lateralen Fernfelddivergenz vermieden werden.

Diese Aufgaben werden erfindungsgemäß durch die Merkmale des Patentanspruches 1 gelöst. Zweckmäßige Ausgestaltungen der Erfindung sind in den jeweiligen Unteransprüchen enthalten.

Ein erfindungsgemäßer Laserbarren umfasst ein Schichtsystem aus einem Halbleitermaterial mit einer aktiven Schicht, wobei das Schichtsystem einen n-Kontakt und p-Kontakt zur Injektion von Ladungsträgern in die aktive Schicht aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette und einer Rückfactette und in lateraler Richtung von einer ersten Seite zu einer zweiten Seite erstrecken und zur Strukturierung die Emitterstrukturen jeweils durch eine sich in longitudinaler Richtung erstreckende Trennstruktur voneinander getrennt sind. Für eine erfindungsgemäß vorgesehenen Variation des Temperaturprofils in lateraler Richtung erfolgt eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen. Insbesondere kann durch die Anpassung in lateraler Richtung ein weitgehend homogenes Temperaturprofil hinsichtlich der Maximaltemperatur der einzelnen Emitterstrukturen beim Betrieb des Laserbarrens erreicht werden.

Das Schichtsystem eines erfindungsgemäßen Laserbarrens kann dabei beispielsweise einen n-Kontakt (z. B. als metallische Kontaktfläche ausgebildet); ein n-Substrat, wobei das n-Substrat auf dem n-Kontakt angeordnet ist; eine n-Mantelschicht, wobei die n-Mantelschicht auf dem n-Substrat angeordnet ist; eine n-Wellenleiterschicht, wobei die n-Wellenleiterschicht auf der n-Mantelschicht angeordnet ist; eine aktiven Schicht, wobei die aktive Schicht auf der n-Wellenleiterschicht angeordnet ist; eine p-Wellenleiterschicht, wobei die p-Wellenleiterschicht auf der aktiven Schicht angeordnet ist; eine p-Mantelschicht, wobei die p-Mantelschicht auf der p-Wellenleiterschicht angeordnet ist; eine strukturierte p-Kontaktschicht, wobei die p-Kontaktschicht auf der p-Mantelschicht angeordnet ist und durch die Strukturierung eine Vielzahl von parallel nebeneinander angeordnete Emitterstrukturen ausbildet, wobei zur Strukturierung in der p-Kontaktschicht die Bereiche zwischen den Emitterstrukturen jeweils durch eine Trennstruktur voneinander getrennt sind und sich die Emitterstrukturen in longitudinaler Richtung zwischen einer Frontfacette und einer Rückfacette und in lateraler Richtung von einer ersten Seite (z. B. links) zu einer zweiten Seite (z. B. rechts) erstrecken; und mehrere p-Kontakte (z. B. als metallische Kontaktelemente ausgebildet), wobei die p-Kontakte 5 auf den Strukturen p-Kontaktschicht 10 aufliegen und eine Injektion von Ladungsträgern in die jeweiligen Emitterstrukturen ermöglichen, umfassen.

Die Idee der Erfindung ist somit, einen Laserbarren mit verringerter lateraler Fernfelddivergenz zur Verfügung zu stellen, bei dem eine Variation des Temperaturprofils in lateraler Richtung dadurch erfolgt, dass eine Anpassung der dissipierten thermischen Leistung (lokalen Wärme) der jeweils der ersten Seite und der zweiten Seite zugewandten äußeren Emitterstrukturen gegenüber den von den äußeren Emitterstrukturen eingeschlossenen inneren Emitterstrukturen vorgenommen wird. Im Gegensatz zu konventionellen Laserbarren gemäß dem Stand der Technik werden die einzelnen Emitterelemente somit nicht identisch zueinander ausgebildet, sondern zur Verringerung der lateralen Fernfelddivergenz können durch geeignete Maßnahmen einige der Emitterelemente derart verändert werden, dass deren dissipierte thermische Leistung angepasst wird. Dadurch kann insbesondere eine Variation des Temperaturprofils in lateraler Richtung zur Anpassung der Temperatur der äußeren Emitterstrukturen an eine Temperatur der von den äußeren Emitterstrukturen eingeschlossenen inneren Emitterstrukturen erfolgen.

Vorzugsweise erfolgt eine Anpassung der dissipierten thermischen Leistung der äußeren Emitterstrukturen graduell über mehrere nebeneinanderliegende äußere Emitterstrukturen hinweg. Es konnte nämlich durch die Erfinder gezeigt werden, dass bereits die Anpassung der dissipierten thermischen Leistung der jeweils äußersten Emitterelemente eines Laserbarrens zu einer deutlichen Anpassung des Temperaturprofils in lateraler Richtung führen kann. Abhängig vom Laserbarrendesign kann eine verbesserte Anpassung jedoch dadurch erreicht werden, dass zusätzlich zu den jeweils äußersten Emitterstrukturen auch bei benachbarten Emitterstrukturen die dissipierte thermische Leistung entsprechend angepasst wird. Besonders bevorzugt nimmt die Stärke der Anpassung in Richtung zu den inneren Emitterstrukturen hin ab. Eine Anpassung der dissipierten thermischen Leistung der äußeren Emitterstrukturen graduell über mehrere nebeneinanderliegende äußere Emitterstrukturen hinweg kann konkret beispielsweise über jeweils drei oder vier oder mehr der äußeren Emitterelemente erfolgen.

Vorzugsweise werden zur Erhöhung der dissipierten thermischen Leistung die elektrischen und/oder optischen Eigenschaften der äußeren Emitterstrukturen gegenüber den inneren Emitterstrukturen angepasst. Die dissipierte thermische Leistung kann dabei insbesondere durch eine Steigerung der Verluste innerhalb der äußeren Emitterstrukturen erhöht werden. Hierzu können im Wesentlichen optische (d. h. die Strahlungsführung betreffend), im Wesentlichen elektrische (d. h. die Stromführung betreffend) oder gemischte (d. h. die Strahlungsführung und die Stromführung betreffend) Anpassungen vorgenommen werden.

Ein effektiver Weg zur Anpassung der elektrischen und/oder optischen Eigenschaften der Emitter und damit zur Erhöhung der dissipierten thermischen Leistung besteht darin, die äußeren Emitterstrukturen (d. h. den innerhalb der Emitterstrukturen gebildeten optischen Resonator) zu modifizieren. Insbesondere können zur Anpassung höhere optische Leistungen innerhalb der äußeren Emitterstrukturen eingeschlossen werden, der Wärmeabtransport aus den äußeren Emitterstrukturen verschlechtert werden, zusätzliche interne optische Verluste (z. B. Streuverluste) bei den äußeren Emitterstrukturen eingeführt werden, die Effektivität der aktiven Bereiche der äußeren Emitterstrukturen verschlechtert werden und/oder hochohmige Strukturen in die Emitterstrukturen eingeführt werden (insbesondere in die inneren Emitterstrukturen).

Vorzugsweise ist zur Erhöhung der internen Resonatorverluste bei den äußeren Emitterstrukturen die Facettenreflektivität den äußeren Emitterstrukturen gegenüber der Facettenreflektivität der inneren Emitterstrukturen erhöht. Es konnte gezeigt werden, dass eine effektive Möglichkeit die abgegebene thermische Leistung der Emitterelemente anzupassen darin besteht, die Facettenreflektivität der Emitterstrukturen (d. h. des innerhalb der Emitterstrukturen ausgebildeten optischen Resonators) zu verändern. Dabei führt eine höhere Facettenreflektivität zu einer Erhöhung der in den Emitterstrukturen gespeicherten optischen Leistung, was wiederum zu einer Erhöhung der internen Resonatorverluste und damit auch zu einer Erhöhung der Temperatur der jeweiligen Emitterstrukturen führt.

Vorzugsweise kann die Facettenreflektivität der Emitterstrukturen durch Reflektoren mittels einer Integration von verteilten Bragg-Gittern (engl. distributed Bragg reflector, DBR), insbesondere von frontseitigen DBR und/oder rückseitigen DBR, oder durch das Aufbringen dielektrischer Spiegelschichten auf die Frontfacetten und/oder die Rückfacetten eingestellt ist. Die Facettenreflektivität kann dabei über die Reflektivität der Reflektorelemente eingestellt werden. Die Einstellung der optischen Eigenschaften eines Resonators durch Anpassung der Reflektivitäten an den Enden ist dem Fachmann an sich bekannt, diese Abhängigkeit wird hier jedoch zur gezielten Anpassung der Temperatur einzelner Emitterelemente eines Laserbarrens zur Verringerung der lateralen Fernfelddivergenz genutzt.

Durch eine Anpassung der Facettenreflektivität kann die Intensität des in den Emitterstrukturen eingeschlossenen Lichts (bzw. des ausgekoppelten Lichts, auch bekannt als Spiegelverlust) kontrolliert werden. Mit zunehmenden Reflexionsgraden der äußeren Emitterstrukturen verringern sich deren Spiegelverluste, es wird mehr optische Energie in den Emitterstrukturen gespeichert und somit steigt auch der Wärmeeintrag im Inneren der Emitterstrukturen. Durch einen erhöhten Wärmeeintrag steigt auch die Temperatur der äußeren Emitterstrukturen.

Vorzugsweise liegt die Reflektivität eines frontseitigen Reflektors (*R*_{f}) der äußeren Emitterstrukturen zwischen 1 % und 30 %, besonders bevorzugt zwischen 1 % und 12 %. Dieser Wertebereich ergibt sich für typische Laserbarren aus dem gemessenen Temperaturabfall bei den äußeren Emitterstrukturen. Mit diesen Werten für die Reflektivität kann typischerweise eine Erhöhung der Temperatur im Bereich bis zu 10 K gegenüber Emitterstrukturen ohne zusätzliche Reflektoren erreicht werden.

Vorzugsweise wird zur Erhöhung des thermischen Widerstandes (*R*ₜₕ) der äußeren Emitterstrukturen gegenüber den inneren Emitterstrukturen bei den äußeren Emitterstrukturen die Länge des gepumpten Bereichs gegenüber der Länge des gepumpten Bereichs der inneren Emitterstrukturen durch eine Ausbildung nicht gepumpter Bereiche verkürzt. Es konnte gezeigt werden, dass eine weitere effektive Möglichkeit die abgegebene thermische Leistung der Emitterelemente anzupassen darin besteht, den thermischen Widerstandes der Emitterstrukturen zu verändern. Ein erhöhter thermischer Widerstand reduziert die Wärmeabfuhr aus den Emitterstrukturen und kann damit auch zu einer Erhöhung der Temperatur der jeweiligen Emitterstrukturen führen.

Vorzugsweise liegt bei den äußeren Emitterstrukturen die Länge des gepumpten Bereichs gegenüber der Länge des gepumpten Bereichs der inneren Emitterstrukturen zwischen 90 % und 20 %, bevorzugter zwischen 80% und 35 %. Beispielsweise beträgt eine typische Länge für den gepumpten Bereich einer inneren Emitterstruktur 4 mm und entspricht der Länge des Resonators. Die Länge des gepumpten Bereichs der äußeren Emitterstrukturen kann dann für eine typischerweise erforderliche Temperaturerhöhung bei diesen Emitterstrukturen beispielsweise auf 1,4 mm verkürzt werden.

Durch eine Verkürzung der Länge des gepumpten Bereichs durch Einführung eines oder mehrerer nicht gepumpter Bereiche innerhalb der äußeren Emitterstrukturen im Gegensatz zu den inneren Emitterstrukturen kann die Wärmeabfuhrfähigkeit der äußeren Emitterstrukturen reduziert werden. Durch die Verkürzung des gepumpten Bereichs nehmen der elektrische Serienwiderstand und der thermische Widerstand zu. Der elektrische Serienwiderstand erhöht sich mit abnehmender Pumplänge (*L*_{gain} < *L*ᵣₑₛₒₙₐₜₒᵣ) nach der Formel *R*ₛ = *ρ*ₛ/(*wL*_{gain}), während der Serienwiderstand der inneren Emitter *R*ₛ = *ρ*ₛ/(*wL*ᵣₑₛₒₙₐₜₒᵣ) folgt. Durch den erhöhten elektrischen Serienwiderstand sinkt der maximale Strom durch die äußeren Emitterstrukturen (bei konstanter zugeführter Spannung) und damit die Wärmeleistung der Emitterstrukturen. Durch den zu stark erhöhten thermischen Widerstand erhöht sich jedoch die Gesamttemperatur innerhalb dieser Emitterstrukturen.

Vorzugsweise erfolgt eine Ausbildung nicht gepumpter Bereiche angrenzend an die Frontfacette und die Rückfacette. Bevorzugt ist dabei eine symmetrische Anordnung der nicht gepumpten Bereiche. Die Lage der gepumpten Bereiche entlang der longitudinalen Achse der Emitterstrukturen kann jedoch frei gewählt werden und für verschiedene Emitterstrukturen individuell bestimmt sein.

Um einen nicht gepumpten Bereich zu erzeugen, kann im einfachsten Fall eine Abscheidung von Kontaktmetall auf diese Bereiche unterdrückt werden. Als Ergebnis wird der Strom größtenteils auf die Abschnitte mit einem darüber befindlichen Kontaktmetall begrenzt. Dabei kann sich jedoch ein Teil der injizierten Ladungsträger ausbreiten und dennoch in die nicht gepumpten Bereiche diffundieren.

Vorzugsweise sind zur Reduzierung der Ladungsträgerausbreitung in den nicht gepumpten passiven Bereichen inerte Ionen mittels tiefer Ionenimplantation implantiert. Es konnte gezeigt werden, dass die nicht gepumpten Bereiche durch Implantation von inerten Ionen effektiver ausgebildet werden können. Die Tiefe der Implantation kann dabei auf eine Implantation bis in die p-Kontaktschicht hinein beschränkt sein. Die Implantation kann sich jedoch auch über die p-Kontaktschicht hinaus bis in die p-Wellenleiterschicht hinein erstrecken. Durch die Ionenimplantation bzw. die tiefe Ionenimplantation wird die Leitfähigkeit der hochgradig p-dotierten Kontakt-, Mantel- und Wellenleiterschichten aufgehoben. Einerseits lässt sich durch eine Ionenimplantation somit der Ladungsträgerfluss auf die gepumpten Bereiche einschränken. Andererseits verhindert diese auch, dass die Ladungsträger in die nicht gepumpten Bereiche diffundieren können.

Vorzugsweise sind zur Erhöhung der internen optischen Verluste (*α*ᵢₙₜ) bei den äußeren Emitterstrukturen Verlustelemente ausgebildet. Der Effekt einer Erhöhung von internen Resonatorverlusten wurde voranstehend bereits erläutert. Diese Verlustelemente können durch das Einbringen von 1-, 2- oder 3-dimensionalen Verlustzentren über lokale Veränderung der Brechzahl oder durch Ätzen von wellenförmigen Strukturen entlang der Längsrichtung des Laserresonators oder durch lokale Erhöhung der Ladungsträgerdichte, z. B. durch Eindiffundieren von Dotierstoffen in die Kristallstruktur erzeugt werden. Solche Strukturen bewirken zusätzliche Streu- und Absorptionsverluste durch Wechselwirkung mit dem Laserlicht. Die daraus resultierende reduzierte Steilheitseffizienz (*η*ₛₗₒₚₑ) des Emitters erhöht die Verlustleistung und bewirkt somit einen Anstieg der Temperatur innerhalb der Emitterstrukturen.

Vorzugsweise liegen die internen optischen Verluste (*α*ᵢₙₜ) der äußeren Emitterstrukturen zwischen 0,6 cm⁻¹ und 1,5 cm⁻¹, bevorzugter zwischen 1 cm⁻¹ und 1,5 cm⁻¹, und noch bevorzugter zwischen 1,2 cm⁻¹ und 1,5 cm⁻¹. Die internen optischen Verluste bei den für Hochleistungslaserdioden typischerweise verwendeten epitaktischen Materialen liegt etwa zwischen 0,3 cm⁻¹ und 0,4 cm⁻¹.

Vorzugsweise sind zur Erhöhung der Wärmeleistung der äußeren Emitterstrukturen gegenüber den inneren Emitterstrukturen bei den äußeren Emitterstrukturen zur Erhöhung der strahlungslosen Rekombination und damit zur Verringerung der internen Quanteneffizienz (*η*ᵢₙₜ) inerte Ionen zumindest abschnittsweise in Richtung der aktiven Schicht hinein implantiert. Durch die dadurch auftretenden selektiven Ladungsträgerverluste kann die interne Quanteneffizienz in diesen Emitterstrukturen herabgesetzt werden, wodurch die Konversionseffizienz *(PCE)* der äußeren Emitterstrukturen verschlechtert wird. Zur Realisierung können zumindest einzelne Bereiche der Halbleitermaterialien mit inerten Ionen tiefimplantiert werden. Durch die bei der Tiefenimplantation eingebrachten Defekte in der Nähe der aktiven Verstärkungsmaterialien steigt die strahlungslose Rekombination gegenüber der strahlenden Rekombination an. Folglich steigt die thermische Verlustleistung innerhalb der modifizierten Emitterstrukturen. Eine Verschlechterung der internen Quanteneffizienz erhöht die interne Erwärmung, indem die strahlungslose Rekombination verstärkt und somit der Wirkungsgrad der Leistungsumwandlung verringert wird.

Die Emitterstruktur kann als Anordnung von implantierten und nicht implantierten Bereichen ausgeführt sein. Bevorzugt ist eine symmetrische Anordnung der implantierten und der nicht implantierten Bereiche, insbesondere können die einzelnen Bereiche jeweils die gleichen Längen aufweisen. Die Lage und Länge der implantierten und nicht implantierten Bereiche entlang der longitudinalen Achse der Emitterstrukturen kann jedoch frei gewählt werden und für verschiedene Emitterstrukturen individuell bestimmt sein. Die Tiefe der Implantation erstreckt sich vorzugsweise von der p-Kontaktschicht über die p-Mantelschicht, p-Wellenleiterschicht und die aktive Schicht bis hinunter zur n-Wellenleiterschicht.

Vorzugsweise sind ausreichend Defekte in die äußeren Emitterstrukturen eingebracht, so dass die internen Quanteneffizienzen (*η*ᵢₙₜ) der äußeren Emitterstrukturen zwischen 50 % und 92 %, bevorzugter zwischen 84 % und 92 % liegen. Die typischerweise erreichbare interne Quanteneffizienz bei für Hochleistungslaserdioden üblicherweise verwendeten epitaktischen Materialen liegt etwa zwischen 95% und 100%.

Vorzugsweise sind zur Erhöhung des Serienwiderstandes (*ρ*ₛ) der inneren Emitterstrukturen inerte Ionen zumindest abschnittsweise in Richtung der aktiven Schicht hinein implantiert. Durch die Erhöhung des Serienwiderstands der inneren Emitterstrukturen kann ein höherer Stromfluss durch die äußeren Emitter erzwungen und dadurch eine zusätzliche Erwärmung der äußeren Emitterstrukturen bewirkt werden. Um den Serienwiderstand der inneren Emittern zu erhöhen, können vorzugsweise Teile der Halbleitermaterialien, z. B. deren Kontaktbereich, mit inerten Ionen implantiert werden. Im Gegensatz zu der voranstehend beschriebenen Ausführungsform einer stromsperrenden Ionenimplantation besteht der Zweck der Ionenimplantation ist darin, den spezifischen Serienwiderstand *ρ*ₛ zu erhöhen, während die Pumplänge L_{gain} weiterhin der Resonatorlänge (*L*_{gain} = *L*ᵣₑₛₒₙₐₜₒᵣ) entspricht. Aufgrund des resultierenden erhöhten Serienwiderstandes durch Vergrößerung von *ρ*ₛ gemäß der Formel *R*ₛ = *ρ*ₛ/(*wL*ᵣₑₛₒₙₐₜₒᵣ) bei den inneren Emitterstrukturen erhöht sich der Betrag des Stromflusses durch die äußeren Emitterstrukturen (bei konstant zugeführter Spannung). Folglich kann auch in den äußeren Emitterstrukturen durch den höheren Strom die hohe Temperatur der inneren Emitterstrukturen erreicht werden. Bevorzugt ist dabei eine symmetrische Anordnung der implantierten und der nicht implantierten Bereiche, insbesondere können die einzelnen Bereiche jeweils die gleichen Längen aufweisen.

Die Emitterstruktur kann als Anordnung von implantierten und nicht implantierten Bereichen ausgeführt sein oder der implantierte Bereich kann sich über die gesamte Länge einer Emitterstruktur erstrecken. Bevorzugt ist eine symmetrische Anordnung der implantierten und der nicht implantierten Bereiche, insbesondere können die einzelnen Bereiche jeweils die gleichen Längen aufweisen. Die Lage und Länge der implantierten und nicht implantierten Bereiche entlang der longitudinalen Achse der Emitterstrukturen kann jedoch frei gewählt werden und für verschiedene Emitterstrukturen individuell bestimmt sein. Die Tiefe der Implantation kann von einer Implantation nur in die p-Kontaktschicht bis hin zu einer Implantation, die sich von der p-Kontaktschicht bis in die p-Wellenleiterschicht erstreckt, reichen.

Vorzugsweise ist der spezifische Serienwiderstand der inneren Emitterstrukturen um einen Faktor 1,2 bis 1,6 gegenüber den äußeren Emitterstrukturen erhöht.

In den untenstehenden Tabellen sind für jede der genannten Ausführungsformen der Erfindung beispielhaft die zur Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erforderlichen Werte für einen typischen Hochleistungslaser angegeben. Die Werte wurden durch Simulation ermittelt, um die Praktikabilität dieses Ansatzes aufzuzeigen. Abhängig von der Art des Laserbarrens können die erforderlichen Anpassungen jedoch auch deutlich von den hier gezeigten Werten abweichen.

Dabei sind in den Tabellen auf der linken Seite jeweils der thermische Widerstand *R*ₜₕ in K/W, die Maximaltemperaturen der inneren bzw. äußeren Emitterstrukturen *T*ᵢ und *T*ₐ bei einer herkömmlichen Hochleistungslaserdiode und die sich daraus ergebende Differenz *dT* zwischen den jeweiligen Maximaltemperaturen der Emitterstrukturen angegeben. Demgegenüber sind in den Tabellen auf der rechten Seite jeweils der entsprechende Variationsparameter und dessen Auswirkungen bei einer erfindungsgemäßen Anpassung dargestellt. Dabei sind die durch die Variation erzielte Temperaturveränderung *dT,* eine daraus resultierende Änderung der Konversionseffizienz *ΔPCE* und ein Faktor *P*_{diss}, um den die dissipierte thermische Leistung in den äußeren Emitterstrukturen durch die erfolgten Anpassungen angehoben wird, angegeben.

**Tabelle 1:**

| *R*ₜₕ (K/W) | *T*ᵢ(°C) @ 900 W | *T*ₐ (°C) @ 900 W | *dT* (K) | *R*_{f} (%) | *dT* (K) | *ΔPCE* (%) | Δ*P*_{diss} (Faktor) |
|---|---|---|---|---|---|---|---|
| 0,05 | 60,58 | 57,08 | 3,50 | 12 | 3,68 | -4,80 | 1,16 |
| 0,2 | 73,88 | 65,40 | 8,48 | 29 | 8,64 | -11,28 | 1,37 |

In Tabelle 1 ist gezeigt, dass mit einem erhöhten Reflektionsgrad *R*_{f} von 12 % bzw. 29 % der Frontfacette der äußeren Emitterstrukturen eine entsprechende Anpassung der Temperaturen erreicht werden kann. Durch einen erhöhten Reflektionsgrad *R*_{f} der Frontfacette können die optischen Eigenschaften der äußeren Emitterstrukturen geändert werden und somit die in den Emitterstrukturen gespeicherte optische Leistung erhöht werden. Dadurch steigen auch die auftretenden Verluste und somit auch die Temperatur der Emitter.

**Tabelle 2:**

| *R*ₜₕ (K/W) | *T*ᵢ(°C) @ 900 W | *T*ₐ (°C) @ 900 W | *dT* (K) | Lgain (µm) | *dT* (K) | *ΔPCE* (%) | Δ*P*_{diss} (Faktor) |
|---|---|---|---|---|---|---|---|
| 0,05 | 60,58 | 57,08 | 3,50 | 1750 | 3,54 | -4,47 | 0,50 |
| 0,2 | 73,88 | 65,40 | 8,48 | 1400 | 8,54 | -10,82 | 0,47 |

In Tabelle 2 ist gezeigt, dass durch eine Verkürzung der Länge des gepumpten Bereichs *L*_{gain} der äußeren Emitterstrukturen gegenüber der Länge des gepumpten Bereichs *L*_{gain} der inneren Emitterstrukturen eine entsprechende Anpassung der Temperaturen erreicht werden kann. Die Länge des gepumpten Bereichs *L*_{gain} der inneren Emitterstrukturen entsprach in diesem Beispiel der Resonatorlänge 4000 µm.

**Tabelle 3:**

| *R*ₜₕ (K/W) | *T*ᵢ (°C) @ 900 W | *T*ₐ (°C) @ 900 W | *dT* (K) | *α*ᵢₙₜ (cm⁻¹) | *dT* (K) | *ΔPCE* (%) | Δ*P*_{diss} (Faktor) |
|---|---|---|---|---|---|---|---|
| 0,05 | 60,58 | 57,08 | 3,50 | 0,85 | 3,39 | -4,43 | 1,14 |
| 0,2 | 73,88 | 65,40 | 8,48 | 1,50 | 8,74 | -11,39 | 1,37 |

In Tabelle 3 ist gezeigt, dass durch eine Erhöhung der internen optischen Verluste *α*ᵢₙₜ der äußeren Emitter eine entsprechende Anpassung der Temperaturen erreicht werden kann. Die internen optischen Verluste können insbesondere durch das Einbringen von Verlustelementen in die Emitterstrukturen erhöht werden. Die Verlustelemente können durch das Einbringen von 1-, 2- oder 3-dimensionalen Verlustzentren in die Kristallstruktur erzeugt werden.

**Tabelle 4:**

| *R*ₜₕ (K/W) | *T*ᵢ (°C) @ 900 W | *T*ₐ (°C) @ 900 W | *dT* (K) | *η*ᵢₙₜ | *dT* (K) | *ΔPCE* (%) | Δ*P*_{diss} (Faktor) |
|---|---|---|---|---|---|---|---|
| 0,05 | 60,58 | 57,08 | 3,50 | 0,92 | 3,76 | -4,90 | 1,16 |
| 0,2 | 73,88 | 65,40 | 8,48 | 0,84 | 8,65 | -11,28 | 1,37 |

In Tabelle 4 ist gezeigt, dass durch eine Herabsetzung der internen Quanteneffizienz *η*ᵢₙₜ der äußeren Emitterstrukturen eine entsprechende Anpassung der Temperaturen erreicht werden kann. Die interne Quanteneffizienz *η*ᵢₙₜ kann insbesondere über eine Verstärkung der strahlungslosen Rekombination an injizierten Ladungsträgern (d. h. an Elektronen und Löchern) erfolgen.

**Tabelle 5:**

| *R*ₜₕ (K/W) | *T*ᵢ(°C) @ 900 W | *T*ₐ (°C) @ 900 W | *dT* (K) | *ρ*ₛ | *dT* (K) | *ΔPCE* (%) | Δ*P*_{diss} (Faktor) |
|---|---|---|---|---|---|---|---|
| 0,05 | 60,58 | 57,08 | 3,50 | 1,2 *ρ*ₛ₀ | -4,02 | -0.11 | 0.84 |
| 0,2 | 73,88 | 65,40 | 8,48 | 1,6 *ρ*ₛ₀ | -8,74 | -0.94 | 0.64 |

In Tabelle 5 ist gezeigt, dass durch eine Erhöhung des spezifischen Serienwiderstands *ρ*ₛ der inneren Emitterstrukturen (beispielsweise durch implantierte inerte Ionen) um einen Faktor 1,2 bis 1,6 gegenüber dem spezifischen Serienwiderstand *ρ*ₛ₀ der äußeren Emitterstrukturen (d. h. der nicht mit inerten Ionen implantierten Emitter) eine entsprechende Anpassung der Temperaturen erreicht werden kann.

Weitere bevorzugte Ausgestaltungen der Erfindung ergeben sich aus den in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

### Kurzbeschreibung der Zeichnungen

Die Erfindung wird nachfolgend in Ausführungsbeispielen anhand der zugehörigen Zeichnung erläutert. Es zeigen:
- Fig. 1: eine schematische Darstellung einer exemplarischen herkömmlichen Laserbarrenstruktur in a) Schrägansicht, b) Seitansicht und c) Aufsicht;
- Fig. 2: a) laterale Temperaturprofile in konventionellen Laserbarren mit 37 Emittern für thermische Widerstände *R*ₜₕ von 0,05 K/W (links) und 0,20 K/W (rechts) bei unterschiedlichen Betriebsleistungen *P*ₒₚ, b) normierte Temperaturprofile der Laserbarren in ihren jeweiligen maximalen Arbeitspunkten und c) die Abhängigkeit der lateralen Temperaturprofile eines Laserbarrens mit *R*ₜₕ = 0,05 K/W vom Randwärmefaktor *BH* ("boundary heat factor") der äußeren Emitterstrukturen an ihrem jeweiligen maximalen Arbeitspunkten;
- Fig. 3a: eine schematische Darstellung einer ersten Ausführungsform einer erfindungsgemäßen Laserbarrenstruktur in kombinierter Auf- und Schrägansicht;
- Fig. 3b: eine Abhängigkeit der Reflektorverluste ("mirror loss"), der Steigungseffizienz *η*ₛₗₒₚₑ ("slope efficiency") und des Schwellstroms *l*ₜₕ ("threshold current") in Abhängigkeit vom Reflexionsgrad *R*_{f} an der Frontfacette;
- Fig. 3c: eine Abhängigkeit der Ausgangsleistung *P*ₒᵤₜ ("output power") und der Konversionseffizienz *PCE* in Abhängigkeit vom Betriebsstrom / für unterschiedliche Reflexionsgrade *R*_{f} an der Frontfacette;
- Fig. 3d: eine Abhängigkeit der Verlustleistung *P*_{diss} ("dissipated power"), der Konversionseffizienz *PCE* und des Temperaturanstiegs *dT* in der aktiven Zone (*dT = T*_{active zone} - *T*_{heat sink}) in Abhängigkeit vom Reflexionsgrad *R*_{f} an der Frontfacette bei maximaler Betriebsspannung (~ 1,55 V);
- Fig. 4: eine schematische Darstellung einer zweiten Ausführungsform einer erfindungsgemäßen Laserbarrenstruktur in kombinierter Auf- und Schrägansicht,
- Fig. 5: eine schematische Darstellung einer dritten Ausführungsform einer erfindungsgemäßen Laserbarrenstruktur in kombinierter Auf- und Schrägansicht,
- Fig. 6: eine schematische Darstellung einer vierten Ausführungsform einer erfindungsgemäßen Laserbarrenstruktur in kombinierter Auf- und Schrägansicht,
- Fig. 7: eine schematische Darstellung einer fünften Ausführungsform einer erfindungsgemäßen Laserbarrenstruktur in kombinierter Auf- und Schrägansicht,
- Fig. 8: eine schematische Darstellung einer sechsten Ausführungsform einer erfindungsgemäßen Laserbarrenstruktur in kombinierter Auf- und Schrägansicht, und
- Fig. 9: eine schematische Darstellung einer siebten Ausführungsform einer erfindungsgemäßen Laserbarrenstruktur in kombinierter Auf- und Schrägansicht.

### Ausführliche Beschreibung der Zeichnungen

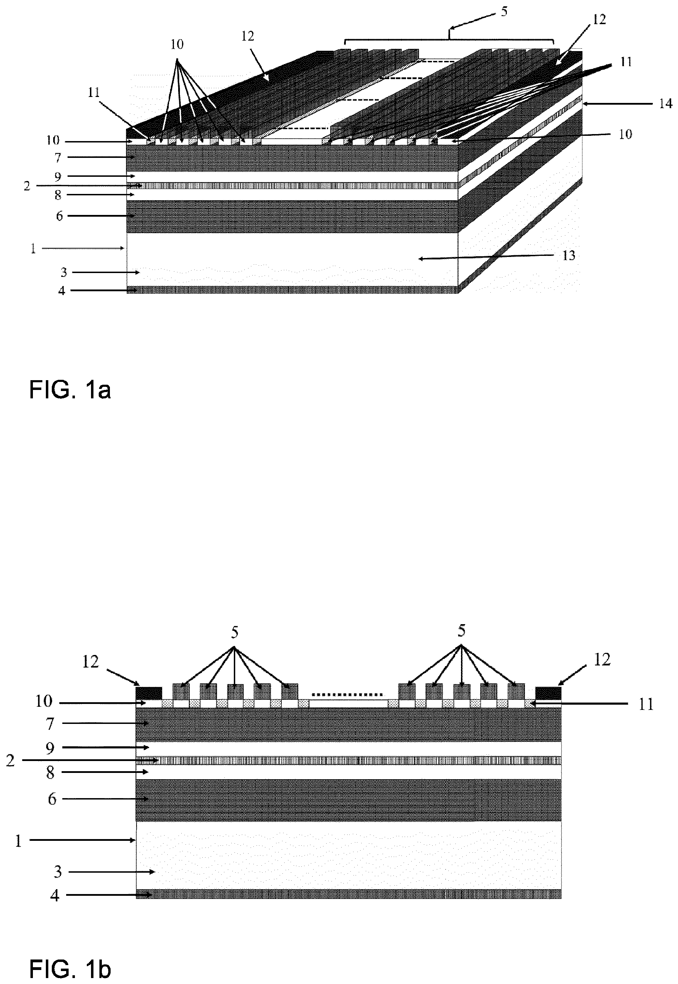

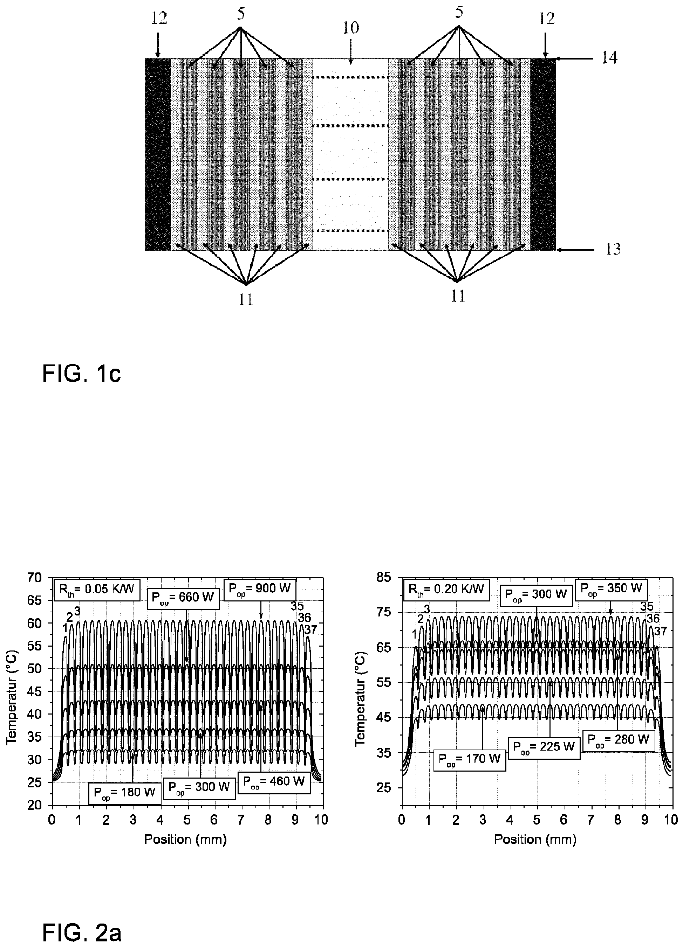

Figur 1 zeigt eine schematische Darstellung einer exemplarischen herkömmlichen Laserbarrenstruktur in a) Schrägansicht, b) Seitansicht und c) Aufsicht. Der Laserbarren 1 umfasst einen n-Kontakt 4 (z. B. als metallische Kontaktfläche ausgebildet); ein n-Substrat 3, wobei das n-Substrat 3 auf dem n-Kontakt 4 angeordnet ist; eine n-Mantelschicht 6, wobei die n-Mantelschicht 6 auf dem n-Substrat 3 angeordnet ist; eine n-Wellenleiterschicht 8, wobei die n-Wellenleiterschicht 8 auf der n-Mantelschicht 6 angeordnet ist; eine aktiven Schicht 2, wobei die aktive Schicht 2 auf der n- Wellenleiterschicht 8 angeordnet ist; eine p-Wellenleiterschicht 9, wobei die p-Wellenleiterschicht 9 auf der aktiven Schicht 2 angeordnet ist; eine p-Mantelschicht 7, wobei die p-Mantelschicht 7 auf der p-Wellenleiterschicht 9 angeordnet ist; eine strukturierte p-Kontaktschicht 10, wobei die p-Kontaktschicht 10 auf der p-Mantelschicht 7 angeordnet ist und durch die Strukturierung eine Vielzahl von parallel nebeneinander angeordnete Emitterstrukturen ausbildet, wobei zur Strukturierung in der p-Kontaktschicht 10 die Bereiche zwischen den Emitterstrukturen jeweils durch eine Trennstruktur 11 voneinander getrennt sind und sich die Emitterstrukturen in longitudinaler Richtung zwischen einer Frontfacette 13 und einer Rückfacette 14 und in lateraler Richtung von einer ersten Seite (z. B. links) zu einer zweiten Seite (z. B. rechts) erstrecken; und mehrere p-Kontakte 5 (z. B. als metallische Kontaktelemente ausgebildet), wobei die p-Kontakte 5 auf den Strukturen p-Kontaktschicht 10 aufliegen und eine Injektion von Ladungsträgern in die jeweiligen Emitterstrukturen ermöglichen.

Den Abschluss zu den beiden Außenseiten des Laserbarrens 1 bildet typischerweise jeweils ein nicht aktiver Blindemitter 12, welcher insbesondere als einfaches dielektrisches Gebiet, als Graben oder als strahlungsloser Emitter ausgebildet sein kann. Die Blindemitter 12 dienen insbesondere dem Schutz des Laserbarrens 1 an den Seitenflächen. Der Bereich in der Mitte des Laserbarrens 1 wurde aus Gründen der besseren Übersicht nur angedeutet, es handelt sich jedoch um eine einfache Fortsetzung der angrenzend gezeigten Strukturen. Der Schichtaufbau kann von dem gezeigten abweichen, insbesondere können die n- und p-Seiten hinsichtlich des Substrates (p-Substrat) vertauscht sein.

Es ist zu erkennen, dass die die einzelnen Laserelemente in einer gemeinsamen Schichtstruktur ausgebildet sind, wobei zur Separation eine Strukturierung der p-Kontaktschicht 10 vorhanden ist. Bei den eingebrachten Trennstrukturen 11 kann es sich insbesondere um mit Ionen implantierte Bereiche (erste lonenimplantationszonen), Gräben oder dielektrische Bereiche handeln. Alternativ können die einzelnen Laserelemente auch durch eine entsprechende Strukturierung einer n-Kontaktschicht, durch einzelne n-Kontakte oder einer p-Kontaktschicht und einer n-Kontaktschicht separiert werden. Ein Laserbarren 1 kann typischerweise eine Anzahl N von 5 bis 200 Laserelementen umfassen, wobei die Laserelemente als Breitstreifenlaser mit einer laterale Breite w zwischen 5 µm und 1200 µm ausgebildet sein können, die Länge der Laserelemente in longitudinaler Richtung beispielsweise zwischen etwa 2 mm und 6 mm liegt und der Abstand d zwischen den einzelnen Laserelementen typischerweise etwa 30 µm bis 100 µm beträgt.

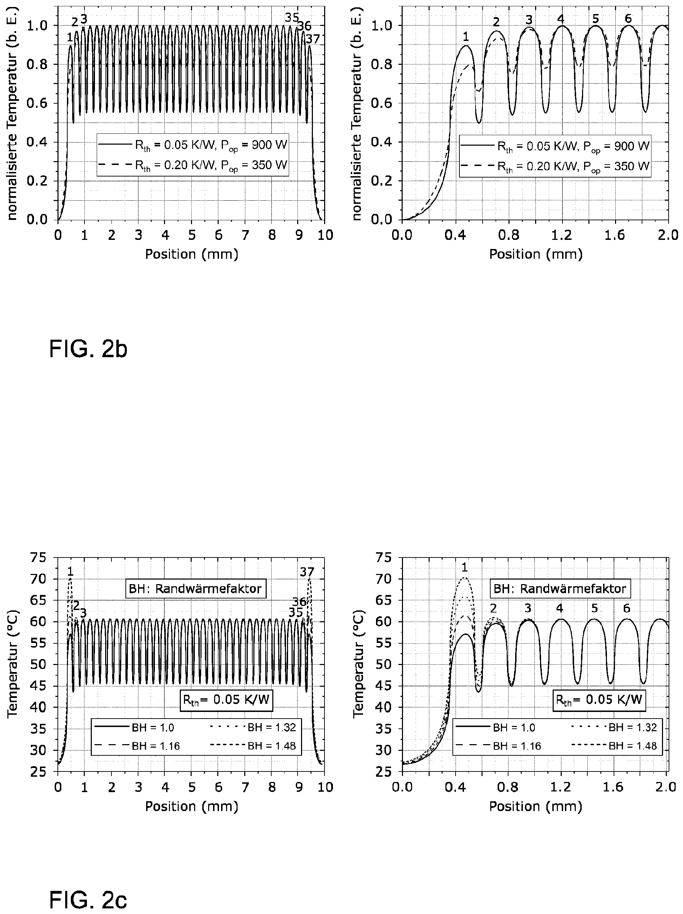

Figur 2 zeigt a) laterale Temperaturprofile in konventionellen Laserbarren mit 37 Emittern für thermische Widerstände *R*ₜₕ von 0,05 K/W (links) und 0,20 K/W (rechts) bei unterschiedlichen Betriebsleistungen *P*ₒₚ, b) normierte Temperaturprofile der Laserbarren in ihren jeweiligen maximalen Arbeitspunkten und c) die Abhängigkeit der lateralen Temperaturprofile eines Laserbarrens mit Rth = 0,05 K/W vom Randwärmefaktor BH ("boundary heat factor") der äußeren Emitterstrukturen an ihrem jeweiligen maximalen Arbeitspunkten. Insbesondere handelt es sich um Temperaturprofile eines Laserbarrens der kW-Klasse bei einer dissipierten thermischen Verlustleistung *P*_{diss} ("dissipated power") von 603 W, wobei die Konversionseffizienz ("PCE") bei 60 % lag. Die einzelnen Laserelemente hatten einen Abstand von 64 µm.

In den Fig. 2a und 2b ist zu erkennen, dass insbesondere die drei jeweils außenliegenden Laserelemente im Betrieb eine geringere Temperatur (Gleichgewichtstemperatur zwischen Wärmeeintrag durch den Laserprozess und Wärmeaustrag durch eine entsprechende Kühlung, jeweils gemessen in der Mitte der aktiven Zone der einzelnen Laserelemente) aufweisen als die inneren Laserelemente. Mit steigendem thermischen Widerstand *R*ₜₕ und entsprechenden erhöhten Gleichgewichtstemperaturen kann insbesondere das jeweilige Außenlaserelement eine bis zu 20 % geringere Maximaltemperatur im Vergleich zu den übrigen Laserelementen des Laserbarrens aufweisen. Die mittleren Laserelemente zeigen bei einem thermischen Widerstand *R*ₜₕ von 0,2 K/W dabei in Abhängigkeit von der Betriebsleistungen *P*ₒₚ einheitliche Temperaturen zwischen etwa 45 °C und 75 °C. Im Bereich zwischen den einzelnen Laserelementen kann die Temperatur wie in Fig. 2b beispielhaft gezeigt jedoch um bis zu 45 % gegenüber dem jeweiligen Maximalwert abfallen.

Die Fig. 2c zeigt hingegen, dass das laterale Temperaturprofil des Laserbarrens durch eine gezielte Erhöhung der Verlustleistung (d. h. der dissipierten Wärme) an den Randemittern modifiziert und somit eine gleichmäßige Temperaturverteilung unter den Emitterstrukturen im Barren erreicht werden kann. Zu diesem Zweck wurde als relatives Maß zur Abschätzung der Stärke der erforderlichen Anpassung ein sogenannter Randwärmefaktor *BH* ("boundary heat factor") der jeweils ganz außen liegenden Emitterstrukturen definiert, welcher angibt, um welchen Faktor die Verlustleistung *P*_{diss} der äußeren Emitterstrukturen erhöht werden muss, um ein weitgehend homogenes Temperaturprofil zu erhalten.

Im dargestellten Beispiel führt ein Randwärmefaktor BH von 1,16 zu einer annähernd homogenen Temperaturverteilung zwischen den Emitterstrukturen. Es ist zu beachten, dass der Randwärmefaktor BH auch auf die direkt an die jeweils ganz außen liegenden Emitterstrukturen angrenzenden inneren Emitterstrukturen wirkt und somit auch deren Temperaturen beeinflussen kann. Eine Erhöhung des Randwärmefaktors BH kann also dazu genutzt werden, den Temperaturabfall der Emitterstrukturen an den Außenrändern eines Laserbarrens zu kompensieren. Insbesondere kann eine Verringerung des lateralen Divergenzwinkels der Gesamtemission des Laserbarrens dadurch erreicht werden, dass ein durch ein asymmetrisches Temperaturprofil auftretender Linseneffekt reduziert wird.

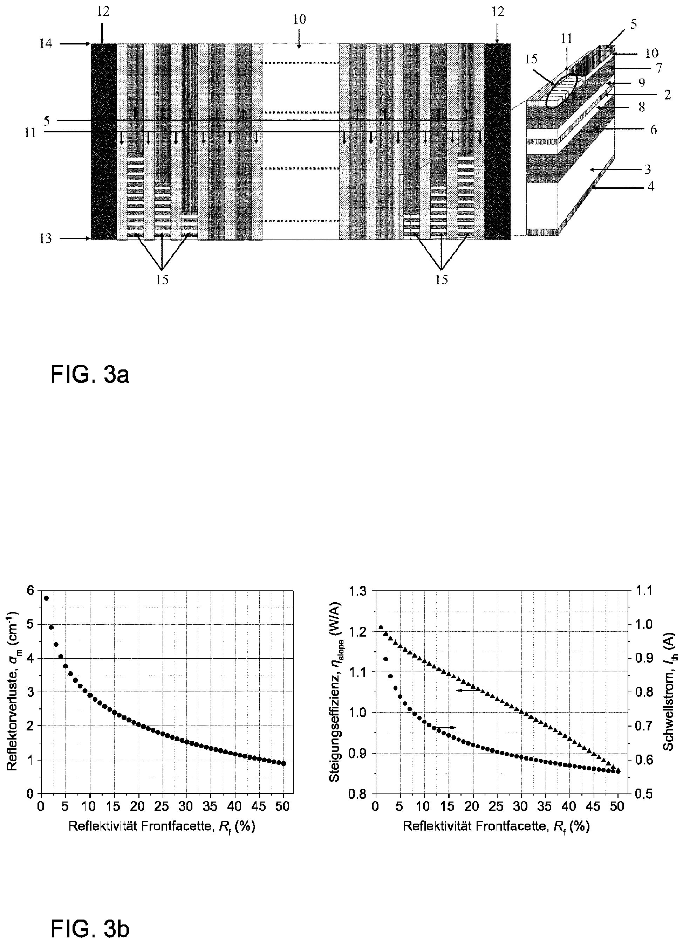

Figur 3a zeigt eine schematische Darstellung einer ersten Ausführungsform einer erfindungsgemäßen Laserbarrenstruktur in kombinierter Auf- und Schrägansicht. Der prinzipielle Aufbau des gezeigten Schichtsystems entspricht dem zu Fig. 1 beschriebenen, die jeweiligen Bezugszeichen und deren Zuordnung zu einzelnen Merkmalen gelten daher entsprechend.

Zur Erhöhung der Temperatur der Außenemitter des Laserbarrens wurde im Bereich der Frontfacetten 13 dieser Laserelemente ein verteiltes Bragg-Gitter 15 (engl. distributed Bragg reflector, DBR) in die Struktur integriert. Solche DBR-Strukturen sind als Rückkoppelelemente zur spektralen Filterung der emittierten Laserstrahlung dem Fachmann bekannt, so dass deren Implementierung ohne Weiteres mit bekannten Technologien erfolgen kann. Der gezeigte frontseitige DBR 15 wird durch eine in der p-Kontaktschicht 10 angeordnete und vorzugsweise bis in die p-Mantelschicht 7 reichende Kammstruktur mit Gräben oder einer den Gräben entsprechenden Brechzahlmodulation erzeugt. Anstatt des frontseitigen DBR 15 kann auch eine dielektrische Verspiegelung der Frontfacetten 13 zur Ausbildung eines Reflektors erfolgen.

Durch die Struktur des DBR 15 oder eines anderen Reflektors lässt sich der Reflexionsgrad *R*_{f} an der Frontfacette 13 einstellen. Dadurch können die optischen Eigenschaften des Resonators geändert werden, wodurch sich dessen Auskoppelverluste reduzieren. Beim DBR 15 kann der Reflexionsgrad *R*_{f} insbesondere über die Anzahl der Schichtpaare des Spiegels eingestellt werden. Ein höherer Reflexionsgrad *R*_{f} führt zu einer geringeren Auskopplung von Laserstrahlung und einer höheren optischen Leistung innerhalb der Emitterstruktur, d. h. im Inneren des zwischen der Frontfacette 13 und der Rückfacette 14 ausgebildeten Resonators, wodurch in der Folge mehr Leistung abgeführt wird und eine höhere Temperatur innerhalb der Emitterstruktur entsteht. Über eine entsprechende Auslegung des Reflexionsgrades *R*_{f} an der Frontfacette 13 bei den Außenlaserelementen kann somit die Temperatur der äußeren Laserelemente an das Temperaturniveau der inneren Laserelemente angepasst werden.

In dem gezeigten Ausführungsbeispiel wurde zusätzlich auch jeweils das zweite und dritte äußere Laserelement entsprechend mit einem DBR 15 im Bereich der Frontfacetten 13 versehen. Durch die unterschiedliche Länge der gezeigten DBR-Strukturen soll angedeutet werden, dass der eingestellte Reflexionsgrades *R*_{f} in Richtung auf die inneren Laserelemente hin abnehmen soll. Die genaue Art der Abnahmefunktion und wie viele Laserelemente an den Außenseiten davon erfasst werden ist jedoch abhängig vom konkreten Design der Laserbarren 1 und der thermischen Kopplung zwischen den einzelnen Laserelementen. Die Darstellung dieser Ausführungsform ist daher rein beispielhaft und steht für eine Vielzahl an möglichen Ausführungsformen.

Unabhängig vom gezeitigten Ausführungsbeispiel kann es sich bei dem zur Erhöhung des Reflexionsgrades R und damit der auftretenden thermischen Verlustleistung verwendeten DBR auch um einen rückseitigen Reflektor handeln oder die Anordnung der einzelnen Reflektoren kann für jedes entsprechend modifizierte Laserelement individuell bestimmt sein. Insbesondere bei Hochleistungslaserbarren ist jedoch im Allgemeinen bereits ein hochreflektierender rückseitiger Reflektor (z. B. ein DBR oder eine dielektrische Spiegelschicht) zur Erhöhung der frontseitig ausgekoppelten optischen Leistung vorhanden, so dass eine weitere Erhöhung der Reflektivität dort nicht mehr möglich ist.

Figur 3b zeigt eine Abhängigkeit der Reflektorverluste ("mirror loss"), der Steigungseffizienz *η*ₛₗₒₚₑ ("slope efficiency") und des Schwellstroms *l*ₜₕ ("threshold current") in Abhängigkeit vom Reflexionsgrad *R*_{f} an der Frontfacette. Als Reflektorverlust (*α*ₘ in cm⁻¹) wird hierbei die aus dem Laserelement durch den Reflektor ausgekoppelte Strahlungsleistung betrachtet. Mit zunehmenden Reflexionsgrad *R*_{f} an der Frontfacette sinken die Reflektorverluste stark ab, wobei die stärkste Abnahme bereits bei kleinen Reflexionsgraden *R*_{f} bis etwa 15 % auftritt. Ein ganz ähnliches Verhalten zeigt der Schwellstrom *l*ₜₕ. Die Steigungseffizienz *η*ₛₗₒₚₑ nimmt hingegen etwa linear mit dem Reflexionsgrad *R*_{f} an der Frontfacette ab.

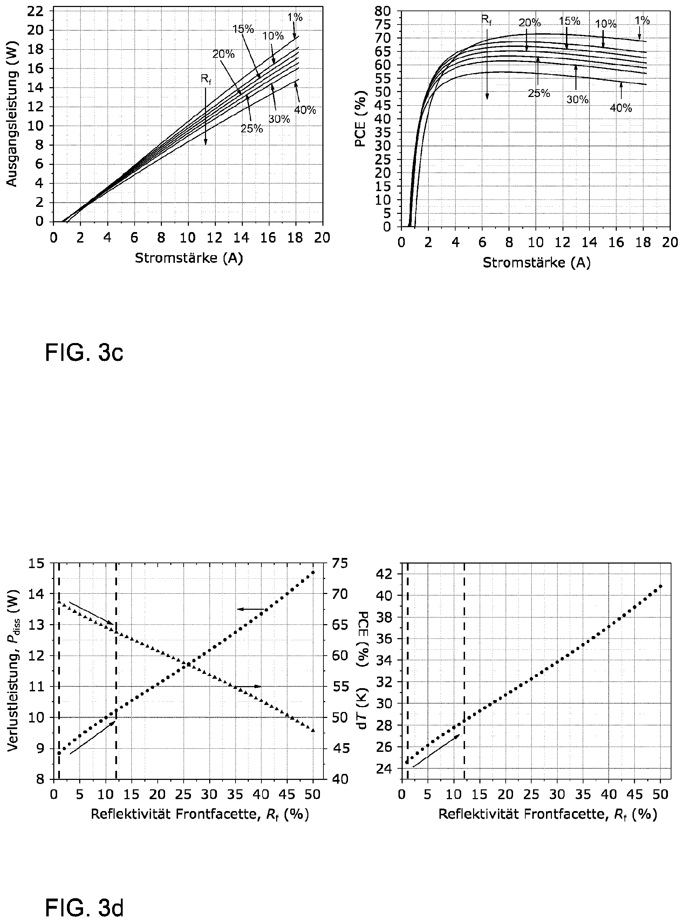

Figur 3c zeigt eine Abhängigkeit der Ausgangsleistung *P*ₒᵤₜ ("output power") und der Konversionseffizienz *PCE* in Abhängigkeit vom Betriebsstrom / für unterschiedliche Reflexionsgrade *R*_{f} an der Frontfacette. Entsprechend den in Fig. 3b gezeigten Abhängigkeiten sinken mit steigendem Reflexionsgrad *R*_{f} die erreichbaren Ausgangsleistungen *P*ₒᵤₜ und die Konversionseffizienzen *PCE.* Dies bedeutet jedoch anderseits, dass ein größerer Anteil der in die Laserelemente eingebrachten Energie in Verlustwärme umgesetzt wird und diese zur Anpassung der Temperatur der äußeren Laserelemente genutzt werden kann.

Figur 3d zeigt eine Abhängigkeit der Verlustleistung *P*_{diss} ("dissipated power"), der Konversionseffizienz *PCE* und des Temperaturanstiegs *dT* in der aktiven Zone in Abhängigkeit vom Reflexionsgrad *R*_{f} an der Frontfacette bei maximaler Betriebsspannung (~ 1,55 V). Die Verlustleistung *P*_{diss} und die Konversionseffizienz *PCE* zeigen ein gegensätzliches lineares Anstiegsverhalten, wobei sich mit Reflexionsgraden *R*_{f} zwischen 1 % und 50% an der Frontfacette die Verlustleistung *P*_{diss} um eine Faktor 1,6 variieren lässt. Die Abhängigkeit im Kurvenverlauf der Verlustleistung *P*_{diss} kann unmittelbar einem entsprechenden Temperaturanstieg *dT* innerhalb der aktiven Zone zugeordnet werden. Dabei können mit Reflexionsgraden *R*_{f} zwischen 1 % und 50 % an der Frontfacette auf den Kühlkörper bezogene Temperaturerhöhungen im aktiven Bereich zwischen 24,5 °C und 41 °C erreicht werden. Zum Ausgleich der in Fig. 2 für Rₜₕ = 0.05 K/W gezeigten Temperaturabweichung bei den Außenemittern herkömmlicher Laserbarren wären daher Reflexionsgrade *R*_{f} zwischen 1 % und 12 % für die in Figur 3a gezeigte Ausführungsform mit frontseitigen Reflektoren ausreichend.

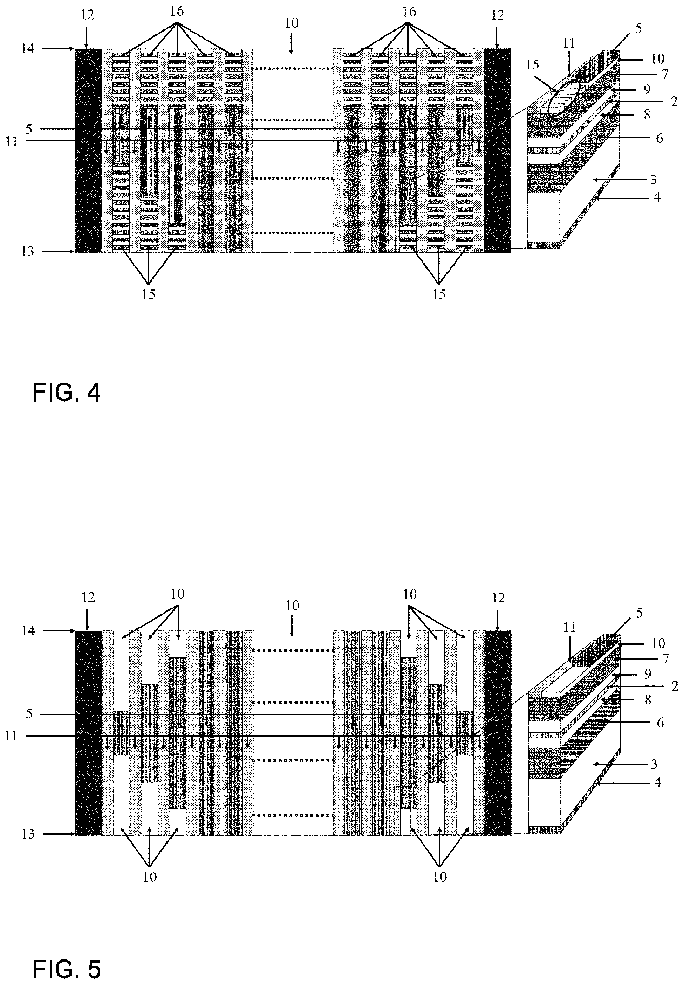

Figur 4 zeigt eine schematische Darstellung einer zweiten Ausführungsform einer erfindungsgemäßen Laserbarrenstruktur in kombinierter Auf- und Schrägansicht. Der prinzipielle Aufbau des gezeigten Schichtsystems entspricht dem zu Fig. 3a beschriebenen, die jeweiligen Bezugszeichen und deren Zuordnung zu einzelnen Merkmalen gelten daher entsprechend. Bei dieser Ausführungsform sind zusätzlich zu den in Fig. 3a gezeigten frontseitigen DBR 15 zusätzlich rückseitige DBR 16 im Bereich der Rückfacette 14 angeordnet. In Gegensatz zur Ausführungsform nach Fig. 3a ist hierbei auch ein optisches Feedback von spektral schmalbandigen DBR Gittern möglich, die ein stabileres und schmalbandigeres Emissionsspektrum erzeugen können. Die Anordnung der einzelnen DBR kann auch vertauscht sein. Ebenfalls möglich ist, dass die Anordnung der beiden DBR für jedes entsprechend modifizierte Laserelement individuell bestimmt ist.

Figur 5 zeigt eine schematische Darstellung einer dritten Ausführungsform einer erfindungsgemäßen Laserbarrenstruktur in kombinierter Auf- und Schrägansicht. Der prinzipielle Aufbau des gezeigten Schichtsystems entspricht dem zu Fig. 1 beschriebenen, die jeweiligen Bezugszeichen und deren Zuordnung zu einzelnen Merkmalen gelten daher entsprechend. Bei dieser Ausführungsform wird in den Außenlaserelementen die Länge des gepumpten Bereichs *L*_{gain} verkürzt. Dies kann beispielsweise dadurch erreicht werden, dass der auf der p-Kontaktschicht 10 aufliegende metallische p-Kontakt 5 nicht über die gesamte Länge *L*ᵣₑₛₒₙₐₜₒᵣ der Laserelemente ausgebildet wird, sondern stattdessen eine Injektion von Ladungsträgern jeweils nur über einen bestimmten Teilbereich erfolgt. In der gezeigten Darstellung sind jeweils die drei äußeren Laserelemente entsprechend angepasst, wobei die Länge der gepumpten Bereiche *L*_{gain} nach außen hin abnimmt. Die Verkürzung erfolgt dabei vorzugsweise symmetrisch zu beiden Enden der Laserelemente.

Die Verkürzung der Länge der gepumpten Bereiche *L*_{gain} führt zu einer Vergrößerung des elektrischen Serienwiderstandes und des thermischen Widerstandes. Durch den erhöhten Serienwiderstand wird der maximal durch die Emitterstruktur fließende Strom verringert. Durch den deutlich erhöhten thermischen Widerstand wird zudem die Temperatur innerhalb der Emitterstrukturen erhöht. Die Lage der gepumpten Bereiche entlang der longitudinalen Achse der Emitterstrukturen kann dabei frei gewählt werden und für verschiedene Laserelemente individuell bestimmt sein.

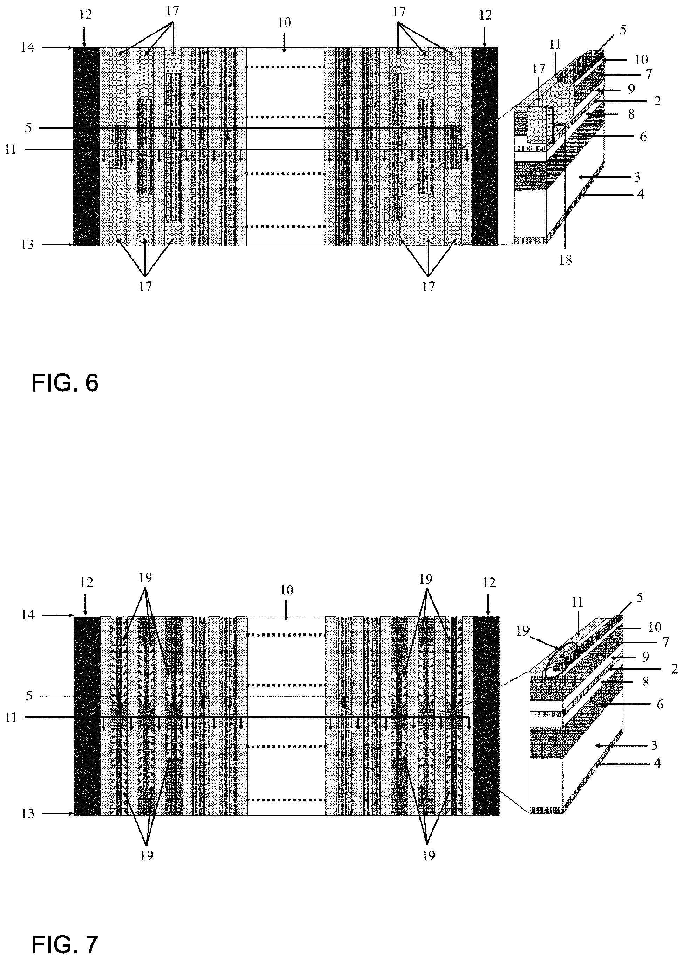

Figur 6 zeigt eine schematische Darstellung einer vierten Ausführungsform einer erfindungsgemäßen Laserbarrenstruktur in kombinierter Auf- und Schrägansicht Der prinzipielle Aufbau des gezeigten Schichtsystems entspricht dem zu Fig. 5 beschriebenen, die jeweiligen Bezugszeichen und deren Zuordnung zu einzelnen Merkmalen gelten daher entsprechend. Bei dieser Ausführungsform erfolgte zusätzlich zu den in Fig. 5 gezeigten Verkürzungen der Länge des gepumpten Bereichs *L*_{gain} durch eine zusätzliche Implantation von inerten Ionen in die nicht gepumpten Bereiche der Außenlaserelemente. Dadurch kann eine Diffusion von Ladungsträgern in die nicht gepumpten Bereiche unterdrückt werden. Die Tiefe 18 dieser zweiten Implantationszonen 17 erstreckt sich dabei vorzugsweise von der p-Kontaktschicht 10 bis hinunter in die p-Wellenleiterschicht 9.

Figur 7 zeigt eine schematische Darstellung einer fünften Ausführungsform einer erfindungsgemäßen Laserbarrenstruktur in kombinierter Auf- und Schrägansicht. Der prinzipielle Aufbau des gezeigten Schichtsystems entspricht dem zu Fig. 1 beschriebenen, die jeweiligen Bezugszeichen und deren Zuordnung zu einzelnen Merkmalen gelten daher entsprechend. Bei dieser Ausführungsform sind zusätzliche Verlustelemente 19 als verlustinduzierende Strukturen hinzugefügt. Die Verlustelemente 19 können beispielsweise 1-, 2- oder 3-dimensionale Verlustzentren über einen lokal veränderten Brechungsindex, geätzte wellenförmige Strukturen entlang der Längsrichtung des Laserresonators, oder Kristallbereiche mit lokal erhöhter Ladungsträgerdichte zum Beispiel durch eindiffundierende Dotierstoffe.

In der Darstellung sind als das Beispiel für Verlustelemente 19 geätzte wellenförmige Strukturen gezeigt. Solche Strukturen führen zu zusätzlichen Streu- und Absorptionsverlusten durch Wechselwirkung des Laserlichts an den Verlustzentren. Die daraus resultierende reduzierte Steilheitseffizienz des Emitters würde die Verlustleistung erhöhen und die Temperatur innerhalb der äußeren Emitter steigern. Die Form und Größe der Verlustzentren ist nicht auf die in der Abbildung gezeigten beschränkt. Die Verlustelementen 19 könne jedoch auch an anderer Stelle im Schichtsystem angeordnet werden. Eine Reduzierung der Breite der p-Kontakte 5 ist nicht notwendig.

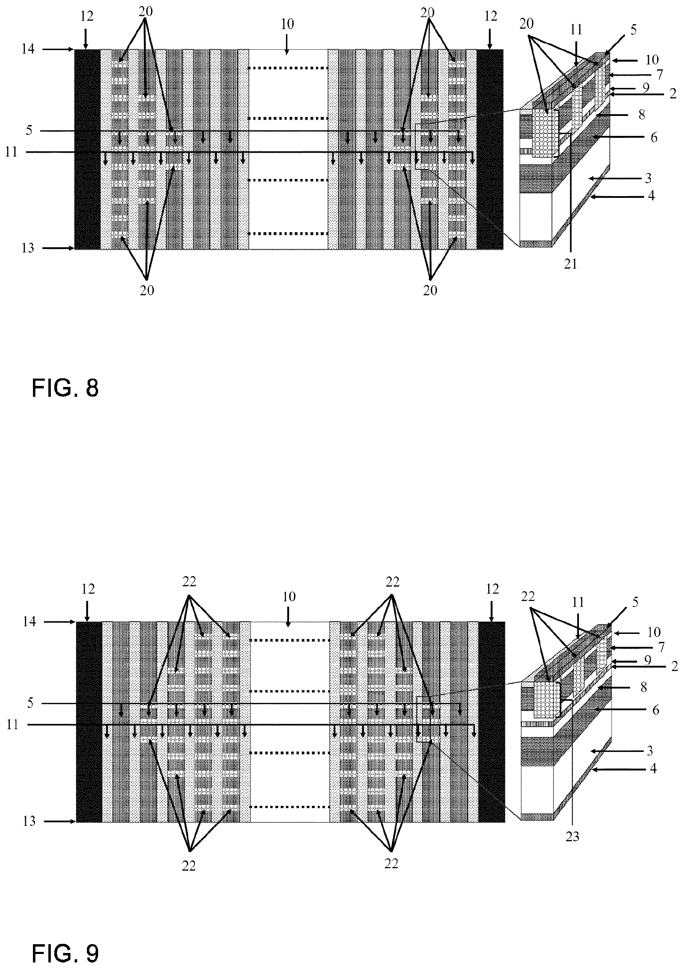

Figur 8 zeigt eine schematische Darstellung einer sechsten Ausführungsform einer erfindungsgemäßen Laserbarrenstruktur in kombinierter Auf- und Schrägansicht. Der prinzipielle Aufbau des gezeigten Schichtsystems entspricht dem zu Fig. 1 beschriebenen, die jeweiligen Bezugszeichen und deren Zuordnung zu einzelnen Merkmalen gelten daher entsprechend. Bei dieser Ausführungsform sind bei den äußeren Emitterstrukturen inerte Ionen zumindest abschnittsweise bis in die aktive Schicht 2 hinein implantiert. Die Tiefe 21 dieser dritten Implantationszonen 20 kann sich dabei vorzugsweise von der p-Kontaktschicht 10 durch die aktive Schicht 2 hindurch bis hinunter in die n-Wellenleiterschicht 8, bevorzugter bis hinunter in die n-Mantelschicht 6, erstrecken. In einem implantierter Bereich, der sich bis hinunter zur aktiven Zone 2 erstreckt, sind die Verluste an injizierten Ladungsträgern durch strahlungslose Rekombination deutlich erhöht und somit wird die interne Quanteneffizienz *η*ᵢₙₜ verringert. Die injizierten Ladungsträger, die dadurch bevorzugt strahlungslos rekombinieren, erhöhen somit die Temperatur der jeweiligen Emitterstruktur. Für eine wirksame Verringerung der internen Quanteneffizienz durch Erhöhung der strahlungslosen Rekombination ist bevorzugt, dass die Implantation über die aktive Zone hinausgeht (oder zumindest bis in diese hineinreicht).

Figur 9 zeigt eine schematische Darstellung einer siebenten Ausführungsform einer erfindungsgemäßen Laserbarrenstruktur in kombinierter Auf- und Schrägansicht. Der prinzipielle Aufbau des gezeigten Schichtsystems entspricht dem zu Fig. 1 beschriebenen, die jeweiligen Bezugszeichen und deren Zuordnung zu einzelnen Merkmalen gelten daher entsprechend. Bei dieser Ausführungsform sind bei den inneren Emitterstrukturen inerte Ionen zumindest abschnittsweise bis in die p-Wellenleiterschicht 9 hinein implantiert. Die Tiefe 23 dieser vierten Implantationszonen 22 kann sich dabei vorzugsweise von der p-Kontaktschicht 10 bis hinunter in die p-Wellenleiterschicht 9 erstrecken. In dieser Ausführungsform werden mit inerten Ionen versehene Abschnitte 22 eingeführt, um den spezifischen elektrischen Serienwiderstand der Halbleiterschichten zu erhöhen. Der daraus für die inneren Emitterstrukturen resultierende erhöhte spezifische Serienwiderstand *ρ*ₛ (*pₛ > ρ*ₛ₀) erzwingt einen höheren Stromfluss durch die äußeren Emitterstrukturen und folglich kann somit auch bei dieser Ausführungsform die Temperatur der äußeren Emitterstrukturen die Temperatur der inneren Emitterstrukturen erreichen.

### Bezugszeichenliste

- 1: Laserbarren
- 2: aktive Schicht
- 3: n-Substrat
- 4: n-Kontakt
- 5: p-Kontakt
- 6: n-Mantelschicht
- 7: p-Mantelschicht
- 8: n-Wellenleiterschicht
- 9: p-Wellenleiterschicht
- 10: p-Kontaktschicht
- 11: Trennstruktur (erste lonenimplantationszone/Graben/dielektrischer Bereich)
- 12: Blindemitter (dielektrischer Bereich/Graben/strahlungsloser Emitter)
- 13: Frontfacette
- 14: Rückfacette
- 15: frontseitiger DBR
- 16: rückseitiger DBR
- 17: zweite lonenimplantationszone
- 18: Tiefe der zweite lonenimplantationszone
- 19: Verlustelemente
- 20: dritte Implantationszone
- 21: Tiefe der dritten Implantationszone
- 22: vierte lonenimplantationszone
- 23: Tiefe der vierten Implantationszone

## Patentansprüche

1. Laserbarren (1), umfassend ein Schichtsystem aus einem Halbleitermaterial mit einer aktiven Schicht (2), wobei das Schichtsystem einen n-Kontakt (4) und p-Kontakt (5) zur Injektion von Ladungsträgern in die aktive Schicht (2) aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette (13) und einer Rückfactette (14) und in lateraler Richtung von einer ersten Seite zu einer zweiten Seite erstrecken und zur Strukturierung die Emitterstrukturen jeweils durch eine sich in longitudinaler Richtung erstreckende Trennstruktur (11) voneinander getrennt sind, wobei zur Variation des Temperaturprofils in lateraler Richtung eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erfolgt ist;
**dadurch gekennzeichnet, dass**
zur Erhöhung der in den Emitterstrukturen umlaufenden Lichtintensität bei den äußeren Emitterstrukturen die Facettenreflektivität gegenüber der Facettenreflektivität der inneren Emitterstrukturen erhöht ist.

2. Laserbarren (1) nach Anspruch 1, wobei die Facettenreflektivität der Emitterstrukturen durch Reflektoren mittels einer Integration von frontseitigen DBR (15) und/oder rückseitigen DBR (16), oder durch das Aufbringen dielektrischer Spiegelschichten auf die Frontfacetten (13) und/oder die Rückfacetten (14) eingestellt ist.

3. Laserbarren (1) nach Anspruch 2, wobei die Reflektivität eines frontseitigen Reflektors der äußeren Emitterstrukturen zwischen 1 % und 30 % beträgt.

4. Laserbarren (1), umfassend ein Schichtsystem aus einem Halbleitermaterial mit einer aktiven Schicht (2), wobei das Schichtsystem einen n-Kontakt (4) und p-Kontakt (5) zur Injektion von Ladungsträgern in die aktive Schicht (2) aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette (13) und einer Rückfactette (14) und in lateraler Richtung von einer ersten Seite zu einer zweiten Seite erstrecken und zur Strukturierung die Emitterstrukturen jeweils durch eine sich in longitudinaler Richtung erstreckende Trennstruktur (11) voneinander getrennt sind, wobei zur Variation des Temperaturprofils in lateraler Richtung eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erfolgt ist;
**dadurch gekennzeichnet, dass**
zur Erhöhung des Serienwiderstandes sowie des thermischen Widerstandes der äußeren Emitterstrukturen gegenüber den inneren Emitterstrukturen bei den äußeren Emitterstrukturen die Länge des gepumpten Bereichs gegenüber der Länge des gepumpten Bereichs der inneren Emitterstrukturen durch eine Ausbildung nicht gepumpter Bereiche verkürzt ist.

5. Laserbarren (1) nach Anspruch 4, wobei bei den äußeren Emitterstrukturen die Länge des gepumpten Bereichs gegenüber der Länge des gepumpten Bereichs der inneren Emitterstrukturen zwischen 90 % und 30 % beträgt.

6. Laserbarren (1) nach Anspruch 4 oder 5, wobei zur Reduzierung der Ladungsträgerausbreitung unter die nicht gepumpten passiven Bereiche inerte Ionen mittels tiefer Ionenimplantation implantiert sind.

7. Laserbarren (1), umfassend ein Schichtsystem aus einem Halbleitermaterial mit einer aktiven Schicht (2), wobei das Schichtsystem einen n-Kontakt (4) und p-Kontakt (5) zur Injektion von Ladungsträgern in die aktive Schicht (2) aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette (13) und einer Rückfactette (14) und in lateraler Richtung von einer ersten Seite zu einer zweiten Seite erstrecken und zur Strukturierung die Emitterstrukturen jeweils durch eine sich in longitudinaler Richtung erstreckende Trennstruktur (11) voneinander getrennt sind, wobei zur Variation des Temperaturprofils in lateraler Richtung eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erfolgt ist;
**dadurch gekennzeichnet, dass**
zur Erhöhung der internen optischen Verluste bei den äußeren Emitterstrukturen Verlustelemente (19) ausgebildet sind, wobei es sich bei Verlustelementen (19) um eingebrachte 1-, 2- oder 3-dimensionalen Verlustzentren zur lokalen Veränderung der Brechzahl oder geätzte wellenförmige Strukturen entlang der Längsrichtung des Laserresonators handelt.

8. Laserbarren (1) nach Anspruch 7, wobei die internen optischen Verluste der äußeren Emitterstrukturen zwischen 0,6 cm⁻¹ und 1,5 cm⁻¹ betragen.

9. Laserbarren (1), umfassend ein Schichtsystem aus einem Halbleitermaterial mit einer aktiven Schicht (2), wobei das Schichtsystem einen n-Kontakt (4) und p-Kontakt (5) zur Injektion von Ladungsträgern in die aktive Schicht (2) aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette (13) und einer Rückfactette (14) und in lateraler Richtung von einer ersten Seite zu einer zweiten Seite erstrecken und zur Strukturierung die Emitterstrukturen jeweils durch eine sich in longitudinaler Richtung erstreckende Trennstruktur (11) voneinander getrennt sind, wobei zur Variation des Temperaturprofils in lateraler Richtung eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erfolgt ist;
**dadurch gekennzeichnet, dass**
zur Erhöhung der Wärmeleistung der äußeren Emitterstrukturen gegenüber den inneren Emitterstrukturen bei den äußeren Emitterstrukturen zur Erhöhung der strahlungslosen Rekombination und damit zur Verringerung der internen Quanteneffizienz inerte Ionen zumindest abschnittsweise in Richtung der aktiven Schicht (2) hinein implantiert sind.

10. Laserbarren (1) nach Anspruch 9, wobei die internen Quanteneffizienzen der äußeren Emitterstrukturen zwischen 50 % und 92 % betragen.

11. Laserbarren (1), umfassend ein Schichtsystem aus einem Halbleitermaterial mit einer aktiven Schicht (2), wobei das Schichtsystem einen n-Kontakt (4) und p-Kontakt (5) zur Injektion von Ladungsträgern in die aktive Schicht (2) aufweist, wobei durch eine Strukturierung des Schichtsystems eine Vielzahl von parallel nebeneinander angeordneten Emitterstrukturen ausbildet ist, wobei sich die Emitterstrukturen in longitudinaler Richtung zwischen einer Frontfacette (13) und einer Rückfactette (14) und in lateraler Richtung von einer ersten Seite zu einer zweiten Seite erstrecken und zur Strukturierung die Emitterstrukturen jeweils durch eine sich in longitudinaler Richtung erstreckende Trennstruktur (11) voneinander getrennt sind, wobei zur Variation des Temperaturprofils in lateraler Richtung eine Anpassung der dissipierten thermischen Leistung der jeweils der ersten Seite und der zweiten Seite zugewandten äußeren Emitterstrukturen gegenüber den von den äußeren Emitterstrukturen eingeschlossenen inneren Emitterstrukturen erfolgt ist;
**dadurch gekennzeichnet, dass**
zur Erhöhung des Serienwiderstandes der inneren Emitterstrukturen inerte Ionen zumindest abschnittsweise in Richtung der aktiven Schicht (2) hinein implantiert sind.

12. Laserbarren (1) nach Anspruch 11, wobei der spezifische Serienwiderstand der inneren Emitterstrukturen um einen Faktor 1,2 bis 1,6 gegenüber dem spezifischen Serienwiderstand der äußeren Emitterstrukturen erhöht ist.

## Claims

1. A laser bar (1), comprising a layer system of a semiconductor material with an active layer (2), the layer system having an n-contact (4) and a p-contact (5) for injecting charge carriers into the active layer (2), a plurality of emitter structures arranged in parallel next to one another being formed by structuring of the layer system, wherein the emitter structures extend in a longitudinal direction between a front facet (13) and a rear facet (14) and in a lateral direction from a first side to a second side and, for the structuring, the emitter structures are separated from one another, respectively, by a separating structure (11) extending in the longitudinal direction; wherein for variation of a temperature profile in the lateral direction, an adjustment of a dissipated thermal power of outer emitter structures facing the first side and the second side, respectively, with respect to inner emitter structures enclosed by the outer emitter structures is made;
**characterized in that**
for increasing light intensity circulating in the emitter structures, facet reflectivity in the outer emitter structures is increased compared to facet reflectivity of the inner emitter structures.

2. The laser bar (1) according to claim 1, wherein the facet reflectivity of the emitter structures is adjusted by reflectors by means of an integration of front-side DBRs (15) and/or rear-side DBRs (16), or by applying dielectric mirror layers to the front facet (13) and/or the rear facet (14).

3. The laser bar (1) according to claim 2, wherein reflectivity of a front-side reflector of the outer emitter structures is between 1% and 30%.

4. A laser bar (1), comprising a layer system of a semiconductor material with an active layer (2), the layer system having an n-contact (4) and a p-contact (5) for injecting charge carriers into the active layer (2), a plurality of emitter structures arranged in parallel next to one another being formed by structuring of the layer system, wherein the emitter structures extend in a longitudinal direction between a front facet (13) and a rear facet (14) and in a lateral direction from a first side to a second side and, for the structuring, the emitter structures are separated from one another, respectively, by a separating structure (11) extending in the longitudinal direction; wherein for variation of a temperature profile in the lateral direction, an adjustment of a dissipated thermal power of outer emitter structures facing the first side and the second side, respectively, with respect to inner emitter structures enclosed by the outer emitter structures is made;
**characterized in that**
to increase a series resistance and a thermal resistance of the outer emitter structures relative to the inner emitter structures, a length of a pumped region of the outer emitter structures is shortened compared to a length of a pumped region of the inner emitter structures by forming non-pumped regions.

5. The laser bar (1) according to claim 4, wherein for the outer emitter structures, the length of the pumped region is between 90% and 30% compared to the length of the pumped region of the inner emitter structures.

6. The laser bar (1) according to claim 4 or 5, wherein inert ions are implanted by deep ion implantation to reduce charge carrier propagation in the non-pumped passive regions.

7. A laser bar (1), comprising a layer system of a semiconductor material with an active layer (2), the layer system having an n-contact (4) and a p-contact (5) for injecting charge carriers into the active layer (2), a plurality of emitter structures arranged in parallel next to one another being formed by structuring of the layer system, wherein the emitter structures extend in a longitudinal direction between a front facet (13) and a rear facet (14) and in a lateral direction from a first side to a second side and, for the structuring, the emitter structures are separated from one another, respectively, by a separating structure (11) extending in the longitudinal direction; wherein for variation of a temperature profile in the lateral direction, an adjustment of a dissipated thermal power of outer emitter structures facing the first side and the second side, respectively, with respect to inner emitter structures enclosed by the outer emitter structures is made;
**characterized in that**
loss elements (19) are formed to increase internal optical losses of the outer emitter structures, wherein the loss elements (19) are created by introducing 1-, 2-, or 3-dimensional loss centers via local modification of a refractive index or by etching wave-like structures along a longitudinal direction of a laser resonator.

8. The laser bar (1) according to claim 7, wherein the internal optical losses of the outer emitter structures are between 0.6 cm⁻¹ and 1.5 cm⁻¹.

9. A laser bar (1), comprising a layer system of a semiconductor material with an active layer (2), the layer system having an n-contact (4) and a p-contact (5) for injecting charge carriers into the active layer (2), a plurality of emitter structures arranged in parallel next to one another being formed by structuring of the layer system, wherein the emitter structures extend in a longitudinal direction between a front facet (13) and a rear facet (14) and in a lateral direction from a first side to a second side and, for the structuring, the emitter structures are separated from one another, respectively, by a separating structure (11) extending in the longitudinal direction; wherein for variation of a temperature profile in the lateral direction, an adjustment of a dissipated thermal power of outer emitter structures facing the first side and the second side, respectively, with respect to inner emitter structures enclosed by the outer emitter structures is made;
**characterized in that**
to increase a thermal power of the outer emitter structures relative to the inner emitter structures, inert ions are implanted at least in sections in a direction of the active layer (2) in the outer emitter structures to increase non-radiative recombination and thus to reduce internal quantum efficiency.

10. The laser bar (1) according to claim 9, wherein the internal quantum efficiency of the outer emitter structures is between 50% and 92%.

11. A laser bar (1), comprising a layer system of a semiconductor material with an active layer (2), the layer system having an n-contact (4) and a p-contact (5) for injecting charge carriers into the active layer (2), a plurality of emitter structures arranged in parallel next to one another being formed by structuring of the layer system, wherein the emitter structures extend in a longitudinal direction between a front facet (13) and a rear facet (14) and in a lateral direction from a first side to a second side and, for the structuring, the emitter structures are separated from one another, respectively, by a separating structure (11) extending in the longitudinal direction; wherein for variation of a temperature profile in the lateral direction, an adjustment of a dissipated thermal power of outer emitter structures facing the first side and the second side, respectively, with respect to inner emitter structures enclosed by the outer emitter structures is made;
**characterized in that**
to increase a series resistance of the inner emitter structures, inert ions are implanted at least in sections in a direction of the active layer (2).

12. The laser bar (1) according to claim 11, wherein the series resistance of the inner emitter structures is increased by a factor of 1.2 to 1.6 compared to a series resistance of the outer emitter structures.

## Revendications

1. Barrette laser (1), comprenant un système de couches constitué d'un matériau semiconducteur avec une couche active (2), ledit système de couches présentant un contact n (4) et un contact p (5) pour l'injection de porteurs de charge dans la couche active (2), le système de couches étant structuré de manière à former une pluralité de structures émettrices disposées parallèlement les unes aux autres, lesdites structures émettrices s'étendant, en direction longitudinale, entre une facette avant (13) et une facette arrière (14), et, en direction latérale, d'un premier côté vers un second côté, les structures émettrices étant séparées les unes des autres, pour la structuration, par une structure de séparation (11) s'étendant en direction longitudinale, une adaptation de la puissance thermique dissipée des structures émettrices externes respectivement tournées vers le premier et le second côté par rapport aux structures émettrices internes comprises entre les structures externes étant réalisée afin de modifier le profil de température en direction latérale ;
**caractérisée en ce que**
afin d'augmenter l'intensité lumineuse circulant dans les structures émettrices externes, la réflectivité des facettes de celle-ci est augmentée par rapport à la réflectivité des facettes des structures émettrices internes.

2. Barrette laser (1) selon la revendication 1, dans laquelle la réflectivité des facettes des structures émettrices est réglée par des réflecteurs au moyen d'une intégration de DBR (15) côté avant et/ou de DBR (16) côté arrière, ou par dépôt de couches de miroirs diélectriques sur les facettes avant (13) et/ou les facettes arrière (14).

3. Barrette laser (1) selon la revendication 2, dans laquelle la réflectivité d'un réflecteur avant des structures émettrices externes est comprise entre 1 % et 30 %.

4. Barrette laser (1), comprenant un système de couches constitué d'un matériau semiconducteur avec une couche active (2), ledit système de couches présentant un contact n (4) et un contact p (5) pour l'injection de porteurs de charge dans la couche active (2), le système de couches étant structuré de manière à former une pluralité de structures émettrices disposées parallèlement les unes aux autres, lesdites structures émettrices s'étendant, en direction longitudinale, entre une facette avant (13) et une facette arrière (14), et, en direction latérale, d'un premier côté vers un second côté, les structures émettrices étant séparées les unes des autres, pour la structuration, par une structure de séparation (11) s'étendant en direction longitudinale, une adaptation de la puissance thermique dissipée des structures émettrices externes respectivement tournées vers le premier et le second côté par rapport aux structures émettrices internes comprises entre les structures externes étant réalisée afin de modifier le profil de température en direction latérale ;
**caractérisée en ce que**
pour augmenter la résistance série ainsi que la résistance thermique des structures émettrices externes par rapport aux structures émettrices internes, la longueur de la zone pompée des structures émettrices externes est réduite par rapport à la longueur de la zone pompée des structures émettrices internes par la formation de zones non pompées.

5. Barrette laser (1) selon la revendication 4, dans laquelle la longueur de la zone pompée des structures émettrices externes est comprise entre 90 % et 30 % de la longueur de la zone pompée des structures émettrices internes.

6. Barrette laser (1) selon la revendication 4 ou 5, dans laquelle, afin de réduire la propagation des porteurs de charge sous les zones passives non pompées, des ions inertes sont implantés par implantation ionique profonde.

7. Barrette laser (1), comprenant un système de couches constitué d'un matériau semiconducteur avec une couche active (2), ledit système de couches présentant un contact n (4) et un contact p (5) pour l'injection de porteurs de charge dans la couche active (2), le système de couches étant structuré de manière à former une pluralité de structures émettrices disposées parallèlement les unes aux autres, lesdites structures émettrices s'étendant, en direction longitudinale, entre une facette avant (13) et une facette arrière (14), et, en direction latérale, d'un premier côté vers un second côté, les structures émettrices étant séparées les unes des autres, pour la structuration, par une structure de séparation (11) s'étendant en direction longitudinale, une adaptation de la puissance thermique dissipée des structures émettrices externes respectivement tournées vers le premier et le second côté par rapport aux structures émettrices internes comprises entre les structures externes étant réalisée afin de modifier le profil de température en direction latérale ;
**caractérisée en ce que**
pour augmenter les pertes optiques internes des structures émettrices externes, des éléments de perte (19) sont prévus, lesdits éléments de perte (19) étant constitués de centres de perte introduits unidimensionnels, bidimensionnels ou tridimensionnels destinés à modifier localement l'indice de réfraction, ou de structures ondulées gravées le long de la direction longitudinale du résonateur laser.

8. Barrette laser (1) selon la revendication 7, dans laquelle les pertes optiques internes des structures émettrices externes sont comprises entre 0,6 cm⁻¹ et 1,5 cm⁻¹ .

9. Barrette laser (1), comprenant un système de couches constitué d'un matériau semiconducteur avec une couche active (2), ledit système de couches présentant un contact n (4) et un contact p (5) pour l'injection de porteurs de charge dans la couche active (2), le système de couches étant structuré de manière à former une pluralité de structures émettrices disposées parallèlement les unes aux autres, lesdites structures émettrices s'étendant, en direction longitudinale, entre une facette avant (13) et une facette arrière (14), et, en direction latérale, d'un premier côté vers un second côté, les structures émettrices étant séparées les unes des autres, pour la structuration, par une structure de séparation (11) s'étendant en direction longitudinale, une adaptation de la puissance thermique dissipée des structures émettrices externes respectivement tournées vers le premier et le second côté par rapport aux structures émettrices internes comprises entre les structures externes étant réalisée afin de modifier le profil de température en direction latérale ;
**caractérisée en ce que**
afin d'augmenter la puissance thermique des structures émettrices externes par rapport aux structures émettrices internes, des ions inertes sont implantés au moins par sections en direction de la couche active (2) afin d'augmenter la recombinaison non radiative et ainsi de réduire l'efficacité quantique interne.

10. Barrette laser (1) selon la revendication 9, dans laquelle les efficacités quantiques internes des structures émettrices externes sont comprises entre 50 % et 92 %.

11. Barrette laser (1), comprenant un système de couches constitué d'un matériau semiconducteur avec une couche active (2), ledit système de couches présentant un contact n (4) et un contact p (5) pour l'injection de porteurs de charge dans la couche active (2), le système de couches étant structuré de manière à former une pluralité de structures émettrices disposées parallèlement les unes aux autres, lesdites structures émettrices s'étendant, en direction longitudinale, entre une facette avant (13) et une facette arrière (14), et, en direction latérale, d'un premier côté vers un second côté, les structures émettrices étant séparées les unes des autres, pour la structuration, par une structure de séparation (11) s'étendant en direction longitudinale, une adaptation de la puissance thermique dissipée des structures émettrices externes respectivement tournées vers le premier et le second côté par rapport aux structures émettrices internes comprises entre les structures externes étant réalisée afin de modifier le profil de température en direction latérale ;
**caractérisée en ce que**
pour augmenter la résistance série des structures émettrices internes, des ions inertes sont implantés au moins par sections en direction de la couche active (2).

12. Barrette laser (1) selon la revendication 11, dans laquelle la résistance série spécifique des structures émettrices internes est augmentée d'un facteur compris entre 1,2 et 1,6 par rapport à la résistance série spécifique des structures émettrices externes.
